# EUROPEAN PATENT SPECIFICATION

(11) **EP 0 848 417 B1**
(45) Date of publication and mention of the grant of the patent: **08.09.2004**
(21) Application number: 97480062.5
(22) Date of filing: 09.09.1997
(51) Int. Cl.: H01L 21/3105, H01L 21/768

(54) **Improvements to the chemical-mechanical polishing of semiconductor wafers**
Verbesserungen im chemisch-mechanischen Polieren von Halbleiterscheiben
Améliorations concernant le polissage mécano-chimique dans des plaquettes semi-conductrices

(30) Priority: 13.12.1996 EP 96480109
(43) Date of publication of application: 17.06.1998
(73) Proprietor: International Business Machines Corporation, Armonk, N.Y. 10504 (US)
(72) Inventor: Fournier, Bernard, 91220 Bretigny-sur-Orge (FR)
(74) Representative: Klein, Daniel Jacques Henri

(56) References cited:
- EP-A- 0 664 559
- EP-A- 0 710 981
- US-A- 5 551 986

## Description

### FIELD OF INVENTION

The present invention relates to the manufacture of high performance semiconductor integrated circuits (IC's) and more particularly to an improved method for planarizing topographical features, such as metal lands formed at the surface of a semiconductor wafer according to the chemical-mechanical (chem-mech) polishing technique. The above method finds extensive applications in the fabrication of planarized multilevel metallized structures in chips which are obtained after dicing the semiconductor wafer as known for those skilled in the art.

### BACKGROUND OF THE INVENTION

A semiconductor chip is typically a silicon die which incorporates a number of active/passive devices interconnected by a pattern of metal wires to form the desired circuit. In VLSI (Very Large Scale Integration) chips, these metal patterns are multilayered and each layer of metal wires is separated from one another by a layer of an insulating material. Interlevel contacts between two planes of metal wires are made by metal studs filling via-holes which are etched through said insulating layer. Cost reduction and circuit performance increase continue to place considerable demand on the manufacturing process to add supplementary wiring levels. However, the above described via-hole based technique, although widely used to day, has multiple limitations and drawbacks as the number of wiring levels increases. With three or four levels of wiring levels being the current state of the art, it is absolutely mandatory to planarize the wafer surface at least after the first level of metallization (M1) has been completed. As a matter of fact, to reduce surface topography related problems associated with non-planar surface, planarization has become a must. There are a number of planarization techniques, but chem-mech polishing (CMP) has demonstrated superior performance and results and as a consequence, it has become a widely accepted planarization technique for multilevel interconnects. CMP is a surface planarization method in which a wafer is rotated against a polishing pad in the presence of a silica(or alumina)-based alkaline slurry while applying pressure. Among a number of advantages, CMP is perfectly adapted to produce planarized tungsten studs or lands according to the so-called dual damascene process of extensive use to date.

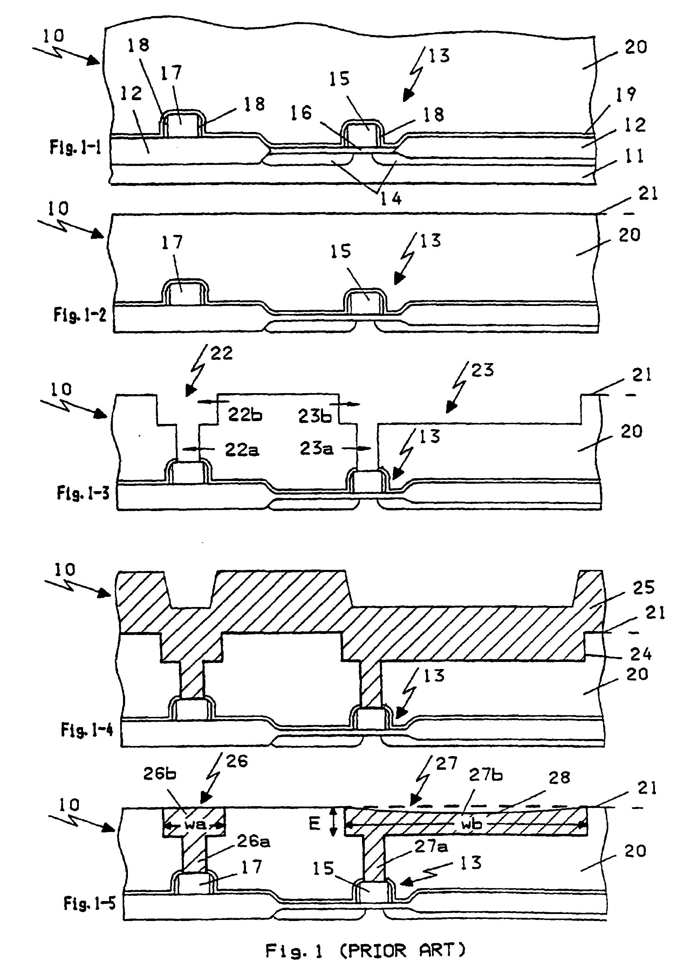

Fig. 1 schematically illustrates a cross sectional view of a semiconductor structure referenced 10 at five different stages of a classic dual damascene process. In Fig. 1-1, reference numeral 11 indicates the P type silicon substrate and numerals 12 are the different field recess oxide (ROX) regions that are used to isolate the devices formed in the substrate. In Fig. 1-1, only a single NFET referenced 13 is shown for sake of simplicity. NFET 13 includes two diffused regions referenced 14, typically the source and the drain regions, and a doped polysilicon gate electrode referenced 15. The gate electrode 15 is isolated from substrate 11 by a thin dielectric layer 16 as standard. Typically, a layer of titanium di-silicide (TiSi2) is deposited on the diffused regions of the NFET 13 to reduce the contact resistance of the ohmic contacts to be subsequently formed therewith. A conductive doped polysilicon land 17 is formed atop a ROX region 12 as shown in the left hand part of Fig. 1-1. Spacers 18 are provided on the sidewalls of gate electrode 15 and polysilicon land 17 and total isolation thereof is achieved by an insulating cap (not shown) as standard. Two insulating layers of Si3N4 and boro-phospho-silicate-glass (BPSG), respectively referenced 19 and 20, conformally coat the whole surface of structure 10.

Now, the irregular surface of BPSG layer 20 is planarized using a conventional CMP step adapted to polish the BPSG material. The structure 10 with a planar main surface referenced 21 is shown in Fig. 1-2. Next, two different sized openings, referenced 22 and 23, are etched through the Si3N4 layer 19 and the BPSG layer 20 to expose the top portion of polysilicon land 17 and polysilicon gate 15 respectively. Narrow opening 22, comprised of parts 22a and 22b, will be used as a via-hole for an electrical contact, while wide opening 23, comprised of parts 23a and 23b, is designed for receiving a conductive line or conductor. At this stage of the dual damascene process, the resulting structure is shown in Fig. 1-3. To that end, a two-step etch process is used, to ensure that each opening is comprised of these two parts. Then, as illustrated in Fig. 1-4, a titanium nitride (TiN) liner layer 24 and a tungsten layer 25 are conformally deposited in sequence onto the structure 10 top surface, for instance by LPCVD. As apparent from Fig. 1-4, the structure 10 surface is bumpy and therefore needs to be planarized again to remove the tungsten material in excess with respect to the BPSG layer 20 main surface referenced 21. This operation is also generally achieved by a CMP process. A detailed description of optimized operating conditions of a conventional CMP process for tungsten planarization will be given hereinbelow. The structure at the final stage of the dual damascene process, after tungsten planarization, is shown in Fig. 1-5. The remaining portions of the tungsten layer 25 that fill openings 22 and 23 will be referred to as tungsten studs and will bear numerals 26 and 27 respectively. For consistency, stud 26 is comprised of parts 26a and 26b, while stud 27 is comprised of parts 27a and 27b as a result of the dual damascene process. Tungsten studs 26 and 27 form an electrical contact with the top surface of polysilicon land 17 and polysilicon gate 15 respectively. Tungsten studs 26 and 27 represent the M1 level of metallization as standard. As apparent from Fig. 1-5, the width Wb of the upper part 27b of stud 27 is greater than the width Wa of the upper part 26b of stud 26 at the structure 10 surface. This is because part 27b will be used as a conductor as mentioned above, unlike part 26b which will be used as a contact. For convenience, upper parts 26b and 27b will be referred to hereinbelow as the narrow and wide tungsten lands. Unfortunately, at this ultimate stage of the dual damascene process, the surface of structure 10 is not as flat as it should be, but rather irregular as a result of the CMP process for tungsten planarization. As clear from Fig. 1-5, the structure 10 surface exhibits a typical depression or cusp 28 so that the wide tungsten land 27b is not perfectly coplanar with the main surface 21 of the BPSG layer 20.

As known for those skilled in the art, there are two causes to that cusp formation. First, the center region of the wafer is etched faster than the edge (or periphery) region and second, the wide tungsten lands (e.g. 27b) are etched faster than the narrow tungsten lands (e.g. 26b) irrespective their location at the surface of the wafer. The problem is thus more acute for the wide tungsten lands situated at the center of the wafer. This erosion phenomena is referred to in the technical literature as the "dishing" effect. The cusp 28 (Fig. 1-5) produced during the conventional CMP process results of an undesired thinning of the thickness E of the wide tungsten land 27b. The "dishing" thus reflects an over-polishing of the wide tungsten lands which is detrimental to the sheet resistance thereof. As a matter of fact, the sheet resistance Rs linearly increases as the land thickness E decreases according to equation Rs = ρ/E wherein ρ is the tungsten resistivity and may reach values outside the upper limit that is acceptable. The increase of the sheet resistance, in turn causes an increase of the land electrical resistance R which finally may lead to an unacceptable degradation of the overall device/circuit performance. However, over-polishing is necessary because under-polishing would even be a worse case with potential electrical shorts between adjacent wide tungsten lands. Therefore, the sheet resistance Rs of the wide tungsten lands and more particularly of those located at the center of the wafer, is an essential parameter of the specifications at this stage of the CMP process. If the sheet resistivity is too high, the wafer must be rejected. It is thus highly desired to have the sheet resistance of the wide tungsten lands maintained around the nominal value and by no means must it be greater than the acceptable upper limit given by the specifications to avoid wafer waste. As a consequence, from a production stand-point, the uniformity of the wide tungsten land sheet resistance around the nominal value, wafer to wafer in a same lot, and the reproducibility of this uniformity, lot to lot, are therefore important requirements. Unfortunately, to date, these parameters are not satisfactory and thus remain a great concern of the CMP technology for tungsten planarization in the dual damascene process.

Accordingly, much effort has been directed so far to modify the CMP processes and equipments in a continuous attempt to reduce said "dishing" effect and its negative impact on the wide tungsten land sheet resistance uniformity, in particular by optimizing the polishing rate. But, because the polishing time is determined by polishing a sample wafer, it significantly varies with a number of process parameters such as the tungsten deposition uniformity, so that the results of the CMP process vary from one wafer to another even in a same lot. As a result, in the case of tungsten planarization with a conventional CMP process, the tolerance (so-called the process window) on the polishing time is close to zero. The wafers are either under-polished (thus they require a new CMP pass to avoid the potential shorts between lands mentioned above) or over-polished which may cause a sheet resistance increase and in turn lead to the rejection of the wafer. The nominal sheet resistance value is very seldom attained on an uniform basis.

Experimental results given just below illustrates the consequences of the "dishing" effect with a such conventional CMP process. The wafers to be polished include the structure 10 of Fig. 1 wherein the BPSG layer 20 has a nominal thickness of 2000 nm and the tungsten layer 25 has a nominal thickness of 1600 nm (final thickness E remaining in land 27b: 1100 nm). The aim is to have a land 27b with a sheet resistance Rs of about .12 ohms/sq, the upper acceptable limit being of about .20 ohms/sq. The wafers were polished with a model 372M sold by WESTECH, Phoenix, AZ, USA, a PANW pad manufactured by FREUDENBERG, Chelmsford, MASS, USA, and a slurry consisting of 10 gr of alumina (Al₂O₃) powder and 80 gr of ferric nitrate (Fe₂(NO₃)₃) diluted in one liter of de-ionized (DI) water. The table/carrier speed ratio which is a key parameter of the CMP process was selected equal to 25/75 rpm as the best compromise for an optimized process. Nine lots of 25 wafers were processed according to the following operating conditions. The polishing time was determined using a sample wafer of the lot as usual.

The conventional CMP process described below is in reality comprised of a preliminary step and a main step.
preliminary step (slurry: Al₂O₃)/Fe₂(NO₃)₃/DI water)

| | | |
|---|---|---|
| (1) | Table/carrier speed | 25/75 rpm |
| (2) | Backside air | 1 psi |
| (3) | Arm oscillation | 10 mm |
| (4) | Oscillation speed | 10 mm/min |
| (5) | Slurry flow rate | 300 cc/min |
| (6) | Polish pressure | 2 psi |
| (7) | Pad temperature | 20 ± 5°C |
| | | |
| (8) | Polishing time | 5 s |

main step (slurry: Al₂O₃/Fₑ2(NO₃)₃/DI water)

| | | |
|---|---|---|
| (1) | Table/carrier speed | 25/75 rpm |
| (2) | Backside air | 3 psi |
| (3) | Arm oscillation | 10 mm |
| (4) | Oscillation speed | 10 mm/min |
| (5) | Slurry flow rate | 100 cc/min |
| (6) | Polish pressure | 3,5 psi |
| (7) | Pad temperature | 20 ± 5°C |
| | | |
| (8) | Polishing time | 600 s |

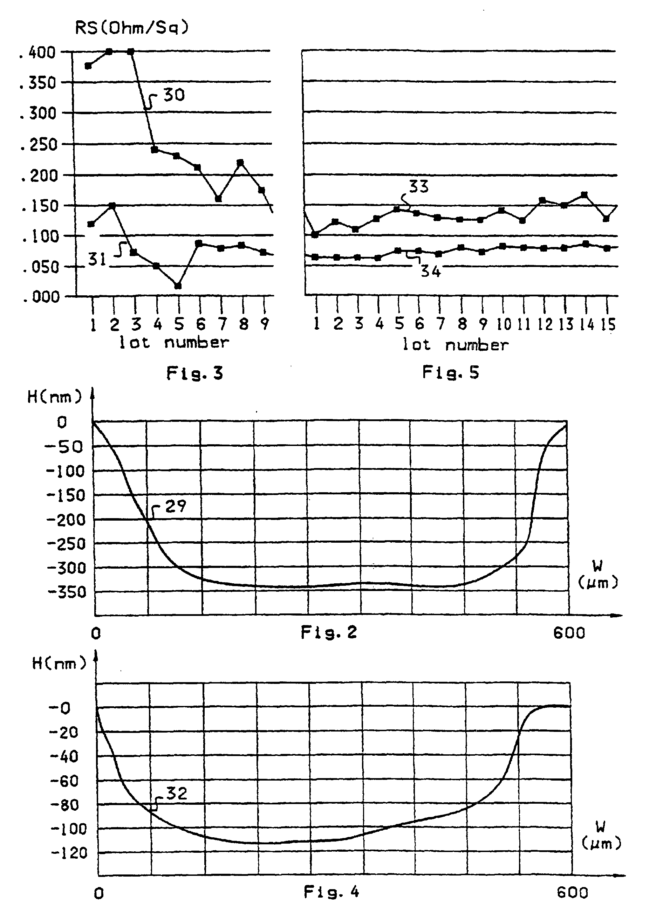

Fig. 2 provides a physical representation of the thinning of a wide tungsten land 27b having a width Wb equal to 600 µm caused by the "dishing" effect when measured with a profilometer for a wafer randomly selected among the group of these nine lots. A profilometer allows an indirect measure of the "dishing" effect through simple electrical resistance measurements performed. This measurement is based on equation R = ρ.L/S wherein ρ is the tungsten resistivity, L and S are respectively the length and the section of the tungsten land 27b, because section S is a function of the land thickness E subject to thinning. Model DEKTAK sold by SLOAN TECHNOLOGY Corp., Santa Barbara, CA, USA is adequate in all respects. As apparent from curve 29 in Fig. 2 which illustrates the depression 28 of Fig. 1-5, the thinning is not negligible in the center of the tungsten land 27b. In this particular case of this selected wafer, the height H of the depression is approximately equal to 350 nm. This value has to be compared with the thickness of 1100 nm of tungsten land 27b. More generally, from a number of experiments, it was observed that this height was varying between 350 and 550 nm.

In Fig. 3, curves 30 and 31 show the extreme variations of the average tungsten sheet resistance Rs of a few wide tungsten lands situated at different locations on the wafer (center/edge) for each wafer of these nine lots. The nominal value given by the specifications is equal to .12 ohms/sq. These sheet resistance variations between wafers of a same lot and between wafers of different lots are clearly not acceptable in the manufacture of advanced ICs. As apparent from Fig. 3, except for lots bearing numbers 7 and 9, all other runs have some wafers whose sheet resistance is outside the acceptable upper limit given by the specifications which is equal to .20 ohms/sq in this case. These wafers must be rejected which has a non negligible cost.

In essence, although CMP is the most commonly polishing technique used to day for planarizing semiconductor wafers at the final stage of the dual damascene process, the sheet resistance non uniformity of the wide tungsten lands at the center of the wafer, wafer to wafer and lot to lot (i.e. the reproducibility), remains a major concern.

### SUMMARY OF THE PRESENT INVENTION

The present invention thus aims to improve the fabrication of integrated circuits and more particularly the step of planarization that is used many times in multilayered metallized structures. Accordingly, there are described hereinbelow some improvements to the conventional chemical-mechanical polishing processes to avoid or at least significantly reduce the above mentioned "dishing" effect. In essence, according to the improved CMP method of the present invention, the polishing is first conducted as standard, i.e. using the specified operating conditions of the conventional CMP process in consideration, except in that, in this first step, the polishing time is reduced in such extent to avoid any over-polishing. Then, an additional CMP step is performed that aims to polish the periphery of the wafer much faster than the center. During this additional step, the operating conditions of the first step are substantially maintained, except in that the flow of polishing slurry is replaced by a flow of de-ionized water. The duration of this additional step depends upon the quantity of tungsten residues that is remaining after the first step mentioned above, and is thus determined experimentally for each type of product. The unpolished residues of tungsten that remain at the periphery of the wafer after the first step are removed during the second step while the tungsten at the center of the wafer is substantially unaffected, limiting thereby the "dishing" effect. The method of the present invention finds extensive usage in the planarization of multilevel metallized semiconductor structures, and in particular, it is perfectly adapted to make tungsten lands coplanar with the dielectric layer in a dual damascene process with high uniformity of the wide tungsten land sheet resistance wafer to wafer in a lot and reproducibility of this uniformity from lot to lot.

### OBJECTS OF THE PRESENT INVENTION

Therefore, it is a primary object of the present invention to provide improvements to the chemical-mechanical polishing of semiconductor wafers.

It is another object of the present invention to provide an improved CMP method for planarizing topographical features, such as metal lands, in multilevel metallized semiconductor chips.

It is still another object of the present invention to provide an improved CMP method for making tungsten lands coplanar with the dielectric layer in a dual damascene process wherein the "dishing" effect in wide lands is substantially reduced.

It is still another object of the present invention to provide an improved CMP method for making tungsten lands coplanar with the dielectric layer in a dual damascene process wherein the tolerance on the polishing time (process window) is no longer a problem.

It is still further another object of the present invention to provide an improved CMP method for making tungsten lands coplanar with the dielectric layer in a dual damascene process wherein the wide tungsten land sheet resistance uniformity (wafer to wafer in a lot) and reproducibility (lot to lot) are improved.

The novel features believed to be characteristic of this invention are set forth in the appended claims. The invention itself, however, as well as other objects and advantages thereof, may be best understood by reference to the following detailed description of an illustrated preferred embodiment to be read in conjunction with the accompanying drawings.

### BRIEF DESCRIPTION OF THE DRAWINGS

Fig. 1 which is comprised of Figs. 1-1 to 1-5 illustrates a conventional dual damascene process at five different stages thereof.
Fig. 2 is a plot generated by a profilometer giving the physical representation of the thinning caused to a wide tungsten land at the center of a wafer selected at random in a lot by a conventional CMP process.
Fig. 3 is a plot showing the variations of the average sheet resistance of wide tungsten lands around the nominal value of .12 ohms/sq for nine lots of 25 wafers when the conventional CMP process is used.
Fig. 4 is a plot generated by a profilometer giving the physical representation of the thinning caused to a wide tungsten land at the center of a wafer selected at random in a lot when the improved CMP method of the present invention is used.
Fig. 5 is a plot showing the variations of the average sheet resistance of wide tungsten lands around the nominal value of .12 ohms/sq for 15 lots of 25 wafers when the improved CMP method of the present invention is used in order to demonstrate that a better uniformity and reproducibilty have been obtained.

### DESCRIPTION OF THE PREFERRED EMBODIMENTS

The structure of Fig. 1-4 will now be planarized according to the method of the present invention. It is to be noted that the improved CMP method of the present invention is an in-line process fully compatible with any known semiconductor manufacturing process, typically of the dual damascene type. According to a first essential feature of the present invention, in a first step, the wafers are polished as standard except in that the polishing time is reduced. It is now determined to avoid any over-polishing of the wide tungsten lands. Another essential feature consists in the implementation of an additional CMP step after the first one has been completed. During this additional step, the previous operating conditions are still maintained except in that a flow of de-ionized water now replaces the flow of slurry. It has been observed by the inventor that this additional step at the end of the standard CMP process allows to continue the polishing (although at a lower rate) of the wide tungsten lands situated at the periphery of the wafer with the slurry (which still impregnates the pad). On the contrary, the removal of the tungsten of the wide lands situated at the center of the wafer is substantially reduced because the slurry which impregnates the pad becomes more and more diluted by the flow of incoming de-ionized water. During the additional step, the polishing is thus less efficient in the center of the wafer than at the periphery, in other words, there is a kind of a self-limitation to the polishing in the center of the wafer caused by the flow of de-ionized water in lieu of the slurry which causes the "dishing" effect.

The duration of this additional step is determined experimentally on a sample product to take in account the residues of tungsten material not completely removed in the first step. The WESTECH model 372M wafer polisher, the PANW pad and the slurry mentioned above are still employed for result consistency.
preliminary step (slurry: Al₂O₃/Fe₂(NO₃)₃/DI water)

| | | |
|---|---|---|
| (1) | Table/carrier speed | 25/75 rpm |
| (2) | Backside air | 1 psi (1 psi= 6.9 x 10³ Pa) |
| (3) | Arm oscillation | 10 mm |
| (4) | Oscillation speed | 10 mm/min |
| (5) | Slurry flow rate | 300 cc/min |
| (6) | Polish pressure | 2 psi |
| (7) | Pad temperature | 20 ± 5°C |
| | | |
| (8) | Polishing time | 5 s |

main step (slurry: Al₂O₃/Fe₂(NO₃)₃/DI water)

| | | |
|---|---|---|
| (1) | Table/carrier speed | 25/75 rpm |
| (2) | Backside air | 3 psi |
| (3) | Arm oscillation | 10 mm |
| (4) | Oscillation speed | 10 mm/min |
| (5) | Slurry flow rate | 100 cc/min |
| (6) | Polish pressure | 3,5 psi |
| (7) | Pad temperature | 20 ± 5°C |
| | | |
| (8) | Polishing time | 540 s |

As apparent from the above, with regards to the conventional CMP process described above in the prior art section, the same operating conditions are maintained, except in that the polishing time has been reduced to 540 s instead of 600 s to avoid any over-polishing at the center of the wafer. As a consequence, at this stage of the process, some unpolished tungsten material remains at the periphery of the wafer. These residues will be now removed with a second CMP step described below.
additional step (DI water instead of slurry)

| | | |
|---|---|---|
| (1) | Table/carrier speed | 25/75 rpm |
| (2) | Backside air | 3 psi |
| (3) | Arm oscillation | 10 mm |
| (4) | Oscillation speed | 10 mm/min |
| (5) | Slurry flow rate | 250 cc/min |
| (6) | Polish pressure | 3,5 psi |
| (7) | Pad temperature | 20 ± 5°C |
| | | |
| (8) | Polishing time | 30 s |

As far as this additional step is concerned, the operating conditions given above for the main step are the same in all respects, except in that, according to the method of the present invention, it is now necessary to replace the flow of slurry by a flow of de-ionized water. In the additional step, the polishing time (30 s in the present case) depends on the quantity of tungsten residues that can be observed at the surface of the sample wafer. This second polishing time is thus determined experimentally for each type of product.

Fig. 4 shows curve 32 that gives a physical representation of the thinning of a wide tungsten land when measured with the DEKTAK profilometer mentioned above. The "dishing" effect was still measured on a wide tungsten land (e.g. 27b) at the center of the wafer having a width Wb equal to 600 µm. As apparent from curve 32, the thinning is more limited and has now a typical maximum height value H of 120 nm in the center of the wide tungsten land, instead of 350 nm with the conventional CMP process illustrated by reference to Fig. 2. More generally, the measured heights were ranging from 80 to 120 nm with the improved CMP process of the present invention.

In Fig. 5, curves 33 and 34 show the variations of the average sheet resistivity Rs of a few selected wide tungsten lands for each wafer of these 15 lots processed with the improved CMP method of the present invention. The nominal sheet resistance value is still equal to .12 ohms/sq. As apparent from Fig. 5, there is a significant improvement in term of sheet resistance uniformity wafer to wafer and in terms of reproducibility lot to lot. The variations that can be now noticed are totally acceptable in the manufacture of advanced ICs. Moreover, the tolerance on the polishing time mentioned above from one wafer to another is no longer a problem with the method of the present invention.

It is remarkable to notice that this additional polishing step which is performed with DI water for a short duration while keeping in place the polishing pad that was used during the said main step provides unexpected advantages. It finishes the polishing at the periphery of the wafer (at a lower rate) because of the remaining slurry that still impregnates the pad while the polishing at the center of the wafer is significantly reduced because the slurry is diluted by the flow of DI water. As a final result, there is no noticeable over-polishing at the center region of the wafer and thus the "dishing" effect is quite limited. It is to be also noted, that although the description has been made by reference to the planarization of tungsten lands in a BPSG layer, the present invention also encompasses other metals and other dielectric materials as well.

The improved CMP method of the present invention finds extensive applications in the semiconductor industry, and in particular in the fabrication of 16 Mbit DRAM and logic products. It is perfectly adapted to future technologies (e.g. 64 Mb and 256 Mb DRAM chips) which will certainly require more than 4 or 5 levels of metallization.

## Claims

1. A method for polishing a semiconductor wafer (11) having a dielectric layer (20) thereon provided with a plurality of openings (22, 23, ...) forming a main surface (21) and a conformal overlying layer (25) of metal that fills said openings in excess; said method comprising the steps of:
a) placing said wafer into a polisher having a polishing pad;
b) in a first step chem-mech polishing the wafer using the pad and a slurry to planarize the metal at the surface of said wafer using the standard operating conditions but with a first polishing time adapted to avoid any over-polishing of the metal with respect to said main surface;
c) in a second step still continuing chem-mech polishing the wafer using the same operating conditions but with de-ionized water instead of said slurry for a second polishing time to make the metal in said openings coplanar with the said main surface irrespective the location of the openings at the surface of the wafer wherein the "dishing" effect is prevented.

2. The method of claim 1 wherein said metal is tungsten and said dielectric is BPSG.

## Patentansprüche

1. Verfahren zum Polieren einer Halbleiterscheibe (Wafer) (11) mit einer darauf befindlichen dielektrischen Schicht 20, die mit einer Vielzahl von Öffnungen (22, 23, ...) versehen ist und eine Hauptfläche (21) bildet, und mit einer formgetreuen Deckschicht (25) aus Metall, welche die Öffnungen mit einem Metallüberschuss ausfüllt; wobei das Verfahren die folgenden Schritte umfasst:
a) Einlegen des Wafers in eine Poliervorrichtung, die einen Polierstempel aufweist;
b) in einem ersten Schritt chemisch-mechanisches Polieren des Wafers mit dem Polierstempel und einer Poliersuspension zum Planarisieren des Metalls an der Oberfläche des Wafers unter Standard-Betriebsbedingungen, jedoch mit einer ersten Polierdauer, die so angepasst ist, dass ein übermäßig starkes Abpolieren des Metalls in Bezug auf die Hauptfläche vermieden wird;
c) in einem zweiten Schritt Fortsetzen des chemisch-mechanischen Polierens des Wafers unter denselben Betriebsbedingungen, bis auf eine zweite Polierdauer, bei der anstelle der Poliersuspension deionisiertes Wasser verwendet wird, um das Metall in den Öffnungen, unabhängig von der Lage der Öffnungen auf der Oberfläche des Wafers, koplanar mit der Hauptfläche zu machen, worin der "Dishing"-Effekt (Kraterbildung) verhindert wird.

2. Verfahren nach Anspruch 1, wobei es sich bei dem Metall um Wolfram und bei dem Dielektrikum um BPSG handelt.

## Revendications

1. Un procédé de polissage d'une tranche à semi-conducteur (11) comprenant sur elle une couche diélectrique (20), munie d'une pluralité d'ouvertures (22, 23,...) formant une surface principale (21), et une couche de revêtement conforme (25) en métal, remplissant lesdites ouvertures avec un excès ; ledit procédé comprenant les étapes consistant à :
a) placer ladite tranche dans une polisseuse munie d'un tampon de polissage ;
b) lors d'une première étape, effectuer le polissage mécano-chimique de la tranche en utilisant le tampon et une boue, pour aplanir le métal à la surface de ladite tranche, en utilisant les conditions de fonctionnement standard, mais avec une première durée de polissage, adaptée pour éviter tout polissage excessif du métal par rapport à ladite surface principale ;
c) lors d'une deuxième étape, continuer encore le polissage mécano-chimique de la tranche, en utilisant les mêmes conditions de fonctionnement, mais en utilisant de l'eau déionisée au lieu de ladite boue, pour une deuxième durée de polissage, pour que le métal se trouvant dans lesdites ouvertures soit coplanaire avec ladite surface principale, indépendamment de l'emplacement des ouvertures sur la surface de la tranche, dans lequel l'effet "d'emboutissage" est empêché.

2. Le procédé selon la revendication 1, dans lequel ledit métal est du tungstène et ledit diélectrique est du BPSG.
